# EUROPEAN PATENT SPECIFICATION

(11) **EP 1 788 448 B1**
(45) Date of publication and mention of the grant of the patent: **29.04.2009**
(21) Application number: 05111012.0
(22) Date of filing: 21.11.2005
(51) Int. Cl.: G03F 7/30, B41C 1/10, G03F 7/085

(54) **Method for making a lithographic printing plate**
Verfahren zur Herstellung einer Lithografiedruckform
Procédé de fabrication d'une plaque d'impression lithographique

(43) Date of publication of application: 23.05.2007
(73) Proprietor: Agfa Graphics N.V., 2640 Mortsel (BE)
(72) Inventor: Williamson, Alexander, Septestraat 27, 2640, Mortsel (BE)
(74) Representative: Goedeweeck, Rudi

(56) References cited:
- EP-A- 1 557 262

## Description

### FIELD OF THE INVENTION

The present invention relates to a method for making a lithographic printing plate whereby an negative-working photopolymer printing plate precursor is image-wise exposed, mounted on a press and processed on-press by applying ink and fountain to remove the unexposed areas from the support. The coating of the precursor comprises a polyvinyl acetate having a hydrolysis degree of less than 60 mol %.

### BACKGROUND OF THE INVENTION

In lithographic printing, a so-called printing master such as a printing plate is mounted on a cylinder of the printing press. The master carries a lithographic image on its surface and a printed copy is obtained by applying ink to said image and then transferring the ink from the master onto a receiver material, which is typically paper. In conventional, so-called "wet" lithographic printing, ink as well as an aqueous fountain solution (also called dampening liquid) are supplied to the lithographic image which consists of oleophilic (or hydrophobic, i.e. ink-accepting, water-repelling) areas as well as hydrophilic (or oleophobic, i.e. water-accepting, ink-repelling) areas. In so-called "driographic" printing, the lithographic image consists of ink-accepting and ink-abhesive (ink-repelling) areas and during driographic printing, only ink is supplied to the master.

Printing masters are generally obtained by the so-called computer-to-film (CtF) method, wherein various pre-press steps such as typeface selection, scanning, color separation, screening, trapping, layout and imposition are accomplished digitally and each color selection is transferred to graphic arts film using an imagesetter. After processing, the film can be used as a mask for the exposure of an imaging material called plate precursor and after plate processing, a printing plate is obtained which can be used as a master. Since about 1995, the so-called 'computer-to-plate' (CtP) method has gained a lot of interest. This method, also called 'direct-to-plate', bypasses the creation of film because the digital document is transferred directly to a printing plate precursor by means of a so-called plate-setter. A printing plate precursor for CtP is often called a digital plate.

Digital plates can roughly be divided in three categories : (i) silver plates, which work according to the silver salt diffusion transfer mechanism; (ii) photopolymer plates which contain a photopolymerizable composition that hardens upon exposure to light and (iii) thermal plates of which the imaging mechanism is triggered by heat or by light-to-heat conversion. Thermal plates are mainly sensitized for infrared lasers emitting at 830 nm or 1064 nm. Photopolymers can be sensitized for blue, green or red light (i.e. wavelength range between 450 and 750 nm), for violet light (i.e. wavelength range between 350 and 450 nm) or for infrared light(i.e. wavelength range between 750 and 1500 nm). Laser sources have been increasingly used to expose a printing plate precursor which is sensitized to a corresponding laser wavelength. Typically, an Ar laser (488 nm) or a FD-YAG laser (532 nm) can be used for exposing a visible light sensitized photopolymer plate. The wide-scale availability of low cost blue or violet laser diodes, originally developed for data storage by means of DVD, has enabled the production of plate-setters operating at shorter wavelength. More specifically, semiconductor lasers emitting from 350 to 450 nm have been realized using an InGaN material. An infrared laser diode emitting around 830 nm or a Nd-YAG laser emitting around 1060 nm can also be used.

Typically, a photopolymer plate is processed in alkaline developer having a pH > 10 and subsequently gummed to protect the plate from contamination, e.g. by oxidation, fingerprints, fats, oil or dust, or from damaging, e.g. by scratches during handling of the plate.

Photopolymer plates are also described in the literature wherein the wet processing and gumming steps are replaced by an on-press processing whereby the imaged precursor is mounted on a press and processed on-press by applying ink and fountain to remove the unexposed areas from the support. Methods for preparing such plates are disclosed in WO 93/05446, US 6,027,857, US 6,171,735, US 6,420,089, US 6,071,675, US 6,245,481, US 6,387,595, US 6,482,571, US 6,576,401, US 6,548,222, WO 03/087939, US 2003/16577 and US 2004/13968. A compound for increasing the adhesion between the photopolymer coating and the support can also added to the printing plate precursor for increasing the resistance of the exposed areas during the processing step and for improving the durability of the plate in the printing process as disclosed in EP 851 299, EP 1 091 251, US 2004/214105, EP 1 491 356, US 2005/39620, EP 1 495 866, EP 1 500 498, EP 1 520 694 and EP 1 557 262. The binder for the photopolymerisable layer may be selected from a broad list of polymers without limitations including linear organic polymers having film-forming properties or having crosslinkable functional groups. Examples of such polymers include acrylic resins, methacrylic resins, polystyrene resins, novolac type resins, polyester resins, synthetic rubbers, natural rubber, and polymers having ethylenically unsaturated bonds. Polymers having hydrophilic groups are preferred and specific examples of such hydrophilic polymers are listed in the literature. Specific examples of such hydrophilic polymers are poly(meth)acrylic acid and salts thereof, polyvinyl alcohol, hydrolyzed polyvinyl acetate having a degree of hydrolysis of 60 % by weight or higher, preferably 80 % by weight or higher, polyvinylpyrrolidone and copolymers of polyvinylpyrrolidone. However, a problem associated with these hydrophilic polymers as binder in lithographic printing plate precursors is an insufficient clean-out of the non-exposed areas by means of fountain and ink in an on-press processing step, even after printing a high number of sheets.

### SUMMARY OF THE INVENTION

It is an object of the present invention to provide a method for making a lithographic printing plate by means of an on-press processing of a photopolymer plate precursor, but also to provide a fast clean-out. This object is realized by the method of claim 1, having the specific feature that the photopolymerizable layer comprises a polyvinyl acetate binder having a hydrolysis degree of less than 60 mol %. The inventors unexpectedly found that the polyvinylalcohols of high hydrolysis degree which should be expected from the prior art based on their high solubility in water, are not suited for obtaining a fast clean-out in an on-press processing, but, on the contrary, that those of a lower degree than 60 mol % are surprisingly best suited for it. The precursor further comprises a compound capable of interacting with the support, hereinafter also referred to as "adhesion promoting compound", which is present in the photopolymerizable layer or in an intermediate layer between the photopolymerizable layer and the support.

Other specific embodiments of the invention are defined in the dependent claims.

### DETAILED DESCRIPTION OF THE INVENTION

In accordance with the present invention, there is provided a method of making a lithographic printing plate comprising the steps of:
(a) providing a lithographic printing plate precursor comprising
   (i) a support having a hydrophilic surface or which is provided with a hydrophilic layer, and
   (ii) a coating provided thereon,
   wherein said coating comprises a photopolymerizable layer and, optionally, an intermediate layer between the photopolymerizable layer and the support,
   wherein said photopolymerizable layer comprises a polymerizable compound, a polymerization initiator and a partially hydrolysed polyvinyl acetate, and
   wherein an adhesion promoting compound is present in the intermediate layer or in the photopolymerizable layer,
   wherein said adhesion promoting compound is a compound capable of interacting with said support,
(b) image-wise exposing said precursor,
(c) optionally, heating the precursor in a preheating unit,
(d) mounting the exposed precursor on a plate cylinder of a lithographic printing press,
(e) developing by rotating the plate cylinder while feeding dampening liquid and/or ink to the coating, thereby removing non-exposed areas of the coating,
characterised in that said polyvinyl acetate has a hydrolysis degree of less than 60 mol%.

The lithographic printing plate precursor used in the method of the present invention is negative-working and develops a lithographic image consisting of hydrophobic and hydrophilic areas at the exposed and non-exposed areas respectively. The hydrophilic areas are defined by the support which has a hydrophilic surface or is provided with a hydrophilic layer. The hydrophobic areas are defined by the coating, hardened upon exposing, optionally followed by a heating step.
Here, "hardened" means that the coating becomes insoluble or non-dispersible for the fountain and ink on the press and may be achieved through polymerization and/or crosslinking of the coating, optionally followed by a heating step to enhance or to speed-up the polymerization and/or crosslinking reaction. In this optional heating step, hereinafter also referred to as "pre-heat", the plate precursor is heated, preferably at a temperature of about 80°C to 150°C and preferably during a dwell time of about 5 seconds to 1 minute.

### The support

A particularly preferred lithographic support is an electrochemically grained and anodized aluminum support. Graining an anodizing of aluminum supports is well known. The acid used for graining can be e.g. nitric acid or sulfuric acid. The acid used for graining preferably comprises hydrogen chloride. Also mixtures of e.g. hydrogen chloride and acetic acid can be used. The relation between electrochemical graining and anodizing parameters such as electrode voltage, nature and concentration of the acid electrolyte or power consumption on the one hand and the obtained lithographic quality in terms of Ra and anodic weight (g/m² of Al₂O₃ formed on the aluminum surface) on the other hand is well known. More details about the relation between various production parameters and Ra or anodic weight can be found in e.g. the article "Management of Change in the Aluminium Printing Industry" by F. R. Mayers, published in the ATB Metallurgie Journal, volume 42 nr. 1-2 (2002) pag. 69.

The anodized aluminum support may be subject to a so-called post-anodic treatment to improve the hydrophilic properties of its surface. For example, the aluminum support may be silicated by treating its surface with a sodium silicate solution at elevated temperature, e.g. 95°C. Alternatively, a phosphate treatment may be applied which involves treating the aluminum oxide surface with a phosphate solution that may further contain an inorganic fluoride. Further, the aluminum oxide surface may be rinsed with a citric acid or citrate solution. This treatment may be carried out at room temperature or may be carried out at a slightly elevated temperature of about 30 to 50°C. A further interesting treatment involves rinsing the aluminum oxide surface with a bicarbonate solution. Still further, the aluminum oxide surface may be treated with polyvinylphosphonic acid, polyvinylmethylphosphonic acid, phosphoric acid esters of polyvinyl alcohol, polyvinylsulfonic acid, polyvinylbenzenesulfonic acid, sulfuric acid esters of polyvinyl alcohol, and acetals of polyvinyl alcohols formed by reaction with a sulfonated aliphatic aldehyde.

Another useful post-anodic treatment may be carried out with a solution of polyacrylic acid or a polymer comprising at least 30 mol% of acrylic acid monomeric units, e.g. GLASCOL E15, a polyacrylic acid, commercially available from ALLIED COLLOIDS.

The grained and anodized aluminum support may be a sheet-like material such as a plate or it may be a cylindrical element such as a sleeve which can be slid around a print cylinder of a printing press.

The support can also be a flexible support, which may be provided with a hydrophilic layer, hereinafter called 'base layer'. The flexible support is e.g. paper, plastic film or aluminum. Preferred examples of plastic film are polyethylene terephthalate film, polyethylene naphthalate film, cellulose acetate film, polystyrene film, polycarbonate film, etc. The plastic film support may be opaque or transparent.

The base layer is preferably a cross-linked hydrophilic layer obtained from a hydrophilic binder cross-linked with a hardening agent such as formaldehyde, glyoxal, polyisocyanate or a hydrolyzed tetra-alkylorthosilicate. The latter is particularly preferred. The thickness of the hydrophilic base layer may vary in the range of 0.2 to 25 µm and is preferably 1 to 10 µm. More details of preferred embodiments of the base layer can be found in e.g. EP-A 1 025 992.

### The coating

The coating on the support comprises a photopolymerizable layer and, optionally, an intermediate layer between the photopolymerizable layer and the support. The photopolymerizable layer comprises a polymerizable compound, a polymerization initiator capable of hardening said polymerizable compound in the exposed areas and a polyvinyl acetate having a hydrolysis degree of less than 60 mol % as binder. The coating further comprises an adhesion promoting compound, which is a compound capable of interacting with the support, and which is present in the photopolymerizable layer or in the intermediate layer.

The thickness of the coating preferably ranges between 0.4 and 10 g/m², more preferably between 0.5 and 5 g/m², most preferably between 0.6 and 3 g/m².

The photopolymerizable layer has a coating thickness preferably ranging between 0.4 and 5.0 g/m² , more preferably between 0.5 and 3.0 g/m², most preferably between 0.6 and 2.2 g/m².

The optional intermediate layer has a coating thickness preferably ranging between 0.001 and 1.5 g/m², more preferably between 0.003 and 1.0 g/m², most preferably between 0.005 and 0.7 g/m² .

### The adhesion promoting compound

The adhesion promoting compound is a compound capable of interacting with said support, preferably a compound having an addition-polymerizable ethylenically unsaturated bond and a functional group capable of interacting with the support, more preferably a functional group capable of interacting with a grained and anodised aluminium support. Under "interacting" is understood each type of physical and/or chemical reaction or process whereby, between the functional group and the support, a bond is formed which can be a covalent bond, an ionic bond, a complex bond, a coordinate bond or a hydrogen-bridge bond, and which can be formed by an adsorption process, a chemical reaction, an acid-base reaction, a complex-forming reaction or a reaction of a chelating group or a ligand. The adhesion promoting compound is present in the photopolymerizable layer and/or in an intermediate layer between the photopolymerizable layer and the support.

The adhesion promoting compound may be selected from at least one of the low molecular weight compounds or polymeric compounds as described in EP-A 851 299 from lines 22 on page 3 to line 1 on page 4, EP-A 1 500 498 from paragraph [0023] on page 7 to paragraph [0052] on page 20, EP-A 1 495 866 paragraph [0030] on page 5 to paragraph [0049] on page 11, EP-A 1 091 251 from paragraph [0014] on page 3 to paragraph [0018] on page 20, and EP-A 1 520 694 from paragraph [0023] on page 6 to paragraph [0060] on page 19. Preferred compounds are those compounds which comprise a phosphate or phosphonate group as functional group capable of adsorbing on the aluminium support and which comprise an addition-polymerizable ethylenic double bond reactive group, especially those described in EP-A 851 299 from lines 22 on page 3 to line 1 on page 4 and EP-A 1 500 498 from paragraph [0023] on page 7 to paragraph [0052] on page 20. Also preferred are those compounds which comprises a tri-alkyloxy silane groups, hereinafter also referred to as "trialkoxy silane" groups, wherein the alkyl is preferably methyl or ethyl, or wherein the trialkyloxy silane groups are at least partially hydrolysed to silanol groups, as functional group capable of adsorbing on the support, especially silane coupling agents having an addition-polymerizable ethylenic double bond reactive group as described in EP-A 1 557 262 paragraph [0279] on page 49 and EP-A 1 495 866 paragraph [0030] on page 5 to paragraph [0049] on page 11.

The adhesion promoting compound may be present in the photopolymerizable layer in an amount ranging between 1 and 50 wt%, preferably between 3 and 30 wt%, more preferably between 5 and 20 wt% of the non-volatile components of the composition.

The adhesion promoting compound may be present in the intermediate layer in an amount of at least 50 wt%, preferably at least 80 wt%, more preferably at least 90 wt%, most preferably 100 wt% of the non-volatile components of the composition.

### The polymerizable compound and the polymerization initiator

According to one embodiment of the present invention, said polymerizable monomer or oligomer is a monomer or oligomer comprising at least one epoxy or vinyl ether functional group and said initiator is a Bronsted acid generator capable of generating free acid, optionally in the presence of a sensitizer, upon exposure, hereinafter said initiator also referred to as "cationic photoinitiator" or "cationic initiator".

Suitable polyfunctional epoxy monomers include, for example, 3,4-epoxycyclohexylmethyl-3,4-epoxycyclohex-ane carboxylate, bis-(3,4 -epoxycyclohexymethyl) adipate, difunctional bisphenol Aepichlorohydrin epoxy resin and multifunctional epichlorohydrinitetraphenylol ethane epoxy resin.

Suitable cationic photoinitiators include, for example, triarylsulfonium hexafluoroantimonate, triarylsulfonium hexafluorophosphate, diaryliodonium hexafluoroantimonate, and haloalkyl substituted s-triazine. It is noted that most cationic initiators are also free radical initiators because, in addition to generating Bronsted acid, they also generate free radicals during photo or thermal decomposition.

According to a more preferred embodiment of the present invention, said polymerizable monomer or oligomer is a ethylenically unsaturated compound, having at least one terminal ethylenic group, hereinafter also referred to as "free-radical polymerizable monomer", and said initiator is a compound, capable of generating free radical, optionally in the presence of a sensitizer, upon exposure, hereinafter said initiator also referred to as "free radical initiator".

Suitable free-radical polymerizable monomers include, for example, multifunctional (meth)acrylate monomers (such as (meth)acrylate esters of ethylene glycol, trimethylolpropane, pentaerythritol, ethoxylated ethylene glycol and ethoxylated trimethylolpropane, multifunctional urethanated (meth)acrylate, and epoxylated (meth)acrylate), and oligomeric amine diacrylates. The (meth)acrylic monomers may also have other double bond or epoxide group, in addition to (meth)acrylate group. The (meth)acrylate monomers may also contain an acidic (such as carboxylic acid) or basic (such as amine) functionality.

Any free radical initiator capable of generating free radical directly or in the presence of a sensitizer upon exposure can be used as a free radical initiator of this invention. Suitable free-radical initiators include, for example, the derivatives of acetophenone (such as 2,2-dimethoxy-2-phenylacetophenone, and 2-methyl-1-[4-(methylthio) phenyll-2-morpholino propan-1-one) ; benzophenone; benzil; ketocoumarin (such as 3-benzoyl-7-methoxy coumarin and 7-methoxy coumarin); xanthone; thioxanthone; benzoin or an alkyl-substituted anthraquinone; onium salts (such as diaryliodonium hexafluoroantimonate, diaryliodonium triflate, (4-(2-hydroxytetradecyl-oxy)-phenyl) phenyliodonium hexafluoroantimonate, triarylsulfonium hexafluorophosphate, triarylsulfonium p-toluenesulfonate, (3-phenylpropan-2-onyl) triaryl phosphonium hexafluoroantimonate, and N-ethoxy(2-methyl)pyridinium hexafluorophosphate, and onium salts as described in U.S. Pat.Nos. 5,955,238,6,037,098, and 5,629,354); borate salts (such as tetrabutylammonium triphenyl(n-butyl)borate, tetraethylammonium triphenyl(n-butyl)borate, diphenyliodonium tetraphenylborate, and triphenylsulfonium triphenyl(n-butyl)borate, and borate salts as described in U.S. Pat. Nos. 6,232,038 and 6,218,076,); haloalkyl substituted s-triazines (such as 2,4-bis(trichloromethyl)-6-(p-methoxy-styryl)-s-triazine, 2,4-bis(trichloromethyl)-6-(4-methoxy-naphth-1-yl)-s-triazine, 2,4-bis(trichloromethyl)-6-piperonyl-s-triazine, and 2,4-bis(trichloromethyl)-6-[(4 -ethoxy-ethylenoxy)-phen-1-yl]-s-triazine, and s-triazines as described in U.S. Pat. Nos. 5, 955, 238, 6,037,098, 6, 010, 824 and 5, 629, 354) ; and titanocene (bis (etha.9-2,4-cyclopentadien-1-yl) bis [2,6-difluoro-3-(1H-pyrrol-1-yl)phenyl) titanium). Onium salts, borate salts, and s-triazines are preferred free radical initiators. Diaryliodonium salts and triarylsulfonium salts are preferred onium salts. Triarylalkylborate salts are preferred borate salts. Trichloromethyl substituted s-triazines are preferred s-triazines.

The known photopolymerization initiators can be used in the composition of the present invention, in a preferred embodiment of the present invention the photopolymerizable composition according to the present invention comprises a hexaaryl-bisimidazole (HABI ; dimer of triaryl-imidazole) compound as a photopolymerization initiator alone or in combination with further photoinitiators.

A procedure for the preparation of hexaarylbisimidazoles is described in DE 1470 154 and their use in photopolymerizable compositions is documented in EP 24 629, EP 107 792, US 4 410 621, EP 215 453 and DE 3 211 312. Preferred derivatives are e. g. 2,4,5,2',4',5'-hexaphenylbisimidazole, 2,2'-bis(2-chlorophenyl)-4,5,4',5'-tetraphenylbisimidazole, 2,2'-bis(2-bromophenyl)-4,5,4',5'-tetraphenylbisimidazole, 2,2'-bis(2,4-dichlorophenyl)-4,5,4',5'-tetraphenylbisimidazole, 2,2'-bis(2-chlorophenyl)-4,5,4',5'-tetrakis(3-methoxyphenyl)bisimidazole, 2,2'-bis(2-chlorophenyl)-4,5,4',5'-tetrakis(3,4,5-trimethoxyphenyl)-bisimidazole, 2,5,2',5'-tetrakis(2-chlorophenyl)-4,4'-bis(3,4-dimethoxyphenyl)bisimidazole, 2,2'-bis(2,6-dichlorophenyl)-4,5,4',5'-tetraphenylbisimidazole, 2,2'-bis(2-nitrophenyl)-4,5,4',5'-tetraphenylbisimidazole, 2,2'-di-o-tolyl-4,5,4',5'-tetraphenylbisimidazole, 2,2'-bis(2-ethoxyphenyl)-4,5,4',5'-tetraphenylbisimidazole and 2,2'-bis(2,6-difluorophenyl)-4,5,4',5'-tetraphenylbisimidazole. The amount of the HABI photoinitiator typically ranges from 0.01 to 30 % by weight, preferably from 0.5 to 20 % by weight, relative to the total weight of the non volatile components of the photopolymerizable composition.

A very high sensitivity can be obtained in the context of the present invention by the combination of an optical brightener as sensitizer and a hexaarylbisimidazole as photoinitiator.

Suitable classes of photoinitiators other than hexaarylbisimidazole compounds include aromatic ketones, aromatic onium salts, organic peroxides, thio compounds, ketooxime ester compounds, borate compounds, azinium compounds, metallocene compounds, active ester compounds and compounds having a carbon-halogen bond, but preferably the composition comprises a non-boron comprising photopolymerization initiator and particularly preferred the photopolymerization initiator comprises no boron comopound. Many specific examples of photoinitiators suitable for the present invention can be found in EP-A 1 091 247. Other preferred initiators are trihalo methyl sulphones.

Preferably hexaarylbisimidazole compounds and/or metallocene compounds are used alone or in combination with other suitable photoinitiators, in particular with aromatic ketones, aromatic onium salts, organic peroxides, thio compounds, ketoxime ester compounds, azinium compounds, active ester compounds or compounds having a carbon halogen bond.

In a preferred embodiment of the present invention the hexaarylbisimidazole compounds make more than 50 mol-%, preferably at least 80 mol-% and particularly preferred at least 90 mol-% of all the photoinitiators used in the photopolymerizable composition of the present invention.

According to another embodiment of the present invention, said polymerizable monomer or oligomer may be a combination of a monomer or oligomer comprising at least one epoxy or vinyl ether functional group and a polymerizable ethylenically unsaturated compound, having at least one terminal ethylenic group, and said initiator may be a combination of a cationic initiator and a free-radical initiator. A monomer or oligomer comprising at least one epoxy or vinyl ether functional group and a polymerizable ethylenically unsaturated compound, having at least one terminal ethylenic group, can be the same compound wherein the compound contains both ethylenic group and epoxy or vinyl ether group. Examples of such compounds include epoxy functional acrylic monomers, such as glycidyl acrylate. The free radical initiator and the cationic initiator can be the same compound if the compound is capable of generating both free radical and free acid. Examples of such compounds include various onium salts such as diaryliodonium hexafluoroantimonate and s-triazines such as 2,4-bis(trichloromethyl)-6-[(4-ethoxyethylenoxy)-phen-1-yl]-s-triazine which are capable of generating both free radical and free acid in the presence of a sensitizer.

The photopolymerizable layer may also comprise a multifunctional monomer. This monomer contains at least two functional groups selected from an ethylenically unsaturated group and/or an epoxy or vinyl ether group. Particular multifunctional monomers for use in the photopolymer coating are disclosed in US 6,410,205 , US 5, 049, 479 , EP 1079276 , EP 1369232 , EP 1369231 EP 1341040 , US 2003/0124460 , EP 1241002, EP 1288720 and in the reference book including the cited refences : Chemistry & Technology UV & EB formulation for coatings, inks & paints - Volume 2 - Prepolymers and Reactive Diluents for UV and EB Curable Formulations by N.S. Allen, M.A. Johnson, P.K.T. Oldring, M.S. Salim - Edited by P.K.T. Oldring - 1991 - ISBN 0 947798102. Particularly preferred are urethane (meth)acrylate multifunctional monomers, which can be used alone or in combination with other (meth)acrylate multifunctional monomers.

The photopolymerizable layer may also comprise a co-initiator. Typically, a co-initiator is used in combination with a free radical initiator and/or cationic initator. Particular co-initiators for use in the photopolymer coating are disclosed in US 6,410,205 , US 5, 049, 479, EP 1079276, 1369232, EP 1369231 EP 1341040, US 2003/0124460 , EP 1241002 , EP 1288720 and in the reference book including the cited refences : Chemistry & Technology UV & EB formulation for coatings, inks & paints - Volume 3 -Photoinitiators for Free Radical and Cationic Polymerisation by K.K. Dietliker - Edited by P.K.T. Oldring - 1991 - ISBN 0 947798161.

The photopolymerizable layer may also comprise an inhibitor. Particular inhibitors for use in the photopolymer coating are disclosed in US 6,410,205, EP 1288720 and the unpublished patent application EP-A 04101955, filed on 6/5/2004.

### The partially hydrolysed polyvinyl acetate as binder of the photopolymerizable layer

The binder of the photopolymerizable layer in the present invention is a polyvinyl acetate having a hydrolysis degree of less than 60 mol %, preferably having a hydrolysis degree of at most 58 mol% and at least 20 mol, most preferably having a hydrolysis degree of at most 56 mol% and at least 40 mol%. As a result of the hydrolysis a copolymer of vinyl acetate and vinyl alcohol is obtained. The coating comprising this partially hydrolysed polyvinyl acetate in the photopolymerizable layer exhibits an excellent clean-out of the non-exposed areas after a few number of printed sheets in the on-press processing step. Under clean-out is understood a complete removal of the coating on non-exposed areas by means of the fountain and ink in an on-press processing step, revealing the hydrophilic surface of the support. The non-exposed areas become hydrophilic, accepting the fountain solution during printing.

Examples of partially hydrolysed polyvinyl acetate according to the present invention are
- POL-01:: ALCOTEX 552P, a polyvinyl acetate with a hydrolysis degree of 54.0-57.0 mol %, commercially available from SYNTHOMER Limited, UK.
- POL-02:: ALCOTEX 55-002H, a polyvinyl acetate with a hydrolysis degree of 54.0-57.0 mol %, commercially available from SYNTHOMER Limited, UK.
- POL-03:: ALCOTEX WD100, a polyvinyl acetate with a hydrolysis degree of 42.0-45.0 mol %, commercially available from SYNTHOMER Limited, UK.
- POL-04:: ALCOTEX WD200, a polyvinyl acetate with a hydrolysis degree of 42.0-45.0 mol %, commercially available from SYNTHOMER Limited, UK.
- POL-05:: ALCOTEX WD30, a polyvinyl acetate with a hydrolysis degree of 48.5 mol %, commercially available from SYNTHOMER Limited, UK.
- POL-06:: POLYVIOL W45/450, a polyvinyl acetate with a hydrolysis degree of 42.0-50.0 mol %, commercially available from WACKER.
- POL-07:: Gohsefimer LL02, a polyvinyl acetate with a hydrolysis degree of 45.0-51.0 mol %, commercially available from Nippon Gohsei.
- POL-08:: Alcotex 25 002, a polyvinyl acetate with a hydrolysis degree of 25 mol %, commercially available from SYNTHOMER Limited, UK.
- POL-9:: Alcotex 20 009, a polyvinyl acetate with a hydrolysis degree of 20 mol %, commercially available from SYNTHOMER Limited, UK.
- POL-10:: Gohsefimer L5407, a polyvinyl acetate with a hydrolysis degree of 34.0-38.0 mol %, commercially available from Nippon Gohsei.
- POL-11:: Gohsefimer L7514, a polyvinyl acetate with a hydrolysis degree of 34.0-38.0 mol %, commercially available from Nippon Gohsei.

The viscosity of the partially hydrolysed polyvinyl of the present invention ranges preferably between 3 and 60 mPa.s, more preferably between 4 and 30 mPa.s, most preferably between 4 and 25 mPa.s. The viscosity is measured on a 4 % by weight aqueous solution at 20°C as defined in DIN 53 015. The average molecular weight M_{W} of the partially hydrolysed polyvinyl acetate of the present invention ranges preferably between 5 000 and 500 000 g/mol, more preferably between 10 000 and 400 000 g/mol, most preferably between 15 000 and 250 000 g/mol.

The amount of the partially hydrolysed polyvinyl acetate of the present invention in the photopolymerizable layer generally ranges from 10 to 90 % by weight, preferably 20 to 80 % by weight, relative to the total weight of the non-volatile components of the composition.

### Other binders of the photopolymerizable layer

The photopolymerizable layer may also further comprise an other binder in admixture with the partially hydrolysed polyvinylacetate of the present invention. The additional binder can be selected from a wide series of organic polymers. Compositions of different binders can also be used. Useful additional binders include for example chlorinated polyalkylene (in particular chlorinated polyethylene and chlorinated polypropylene), polymethacrylic acid alkyl esters or alkenyl esters (in particular polymethyl (meth)acrylate, polyethyl (meth)acrylate, polybutyl (meth)acrylate, polyisobutyl (meth)acrylate, polyhexyl (meth)acrylate, poly(2-ethylhexyl) (meth)acrylate and polyalkyl (meth)acrylate copolymers of (meth) acrylic acid alkyl esters or alkenyl esters with other copolymerizable monomers (in particular with (met)acrylonitrile, vinyl chloride, vinylidene chloride, styrene and/or butadiene), polyvinyl chloride (PVC, vinylchloride/ (meth)acrylonitrile copolymers, polyvinylidene chloride (PVDC), vinylidene chloride/(meth)acrylonitrile copolymers, polyvinyl acetate, polyvinyl alcohol, polyvinyl pyrrolidone, copolymers of vinyl pyrrolidone or alkylated vinyl pyrrolidone, polyvinyl caprolactam, copolymers of vinyl caprolactam, poly (meth)acrylonitrile, (meth)acrylonitrile/styrene copolymers, (meth)acrylamide/alkyl (meth)acrylate copolymers, (meth)acrylonitrile/butadiene/styrene (ABS) terpolymers, polystyrene, poly(α-methylstyrene), polyamides, polyurthanes, polyesters, methyl cellulose, ethylcellulose, acetyl cellulose, hydroxy-(C₁-C₄-alkyl) cellulose, carboxymethyl cellulose, polyvinyl formal and polyvinyl butyral. Particulary preferred binders are polymers having vinylcaprolactam, vinylpyrrolidone or alkylated vinylpyrrolidone as monomeric units. Alkylated vinylpyrrolidone polymers can be obtained by grafting alfa-olefines onto the vinylpyrrolidone polymer backbone. Typical examples of such products are the Agrimer AL Graft polymers commercially available from ISP. The length of the alkylation group may vary from C₄ to C₃₀. Other useful binders are binders containing carboxyl groups, in particular copolymers containing monomeric units of α,β-unsaturated carboxylic acids or monomeric units of α,β-unsaturated dicarboxylic acids (preferably acrylic acid, methacrylic acid, crotonic acid, vinylacetic acid, maleic acid or itaconic acid). By the term "copolymers" are to be understood in the context of the present invention as polymers containing units of at least 2 different monomers, thus also terpolymers and higher mixed polymers. Particular examples of useful copolymers are those containing units of (meth)acrylic acid and units of alkyl (meth)acrylates, allyl (meth)acrylates and/or (meth)acrylonitrile as well as copolymers containing units of crotonic acid and units of alkyl (meth)acrylates and/or (meth)acrylonitrile and vinylacetic acid/alkyl (meth)acrylate copolymers. Also suitable are copolymers containing units of maleic anhydride or maleic acid monoalkyl esters. Among these are, for example, copolymers containing units of maleic anhydride and styrene, unsaturated ethers or esters or unsaturated aliphatic hydrocarbons and the esterification products obtained from such copolymers. Further suitable binders are products obtainable from the conversion of hydroxyl-containing polymers with intramolecular dicarboxylic anhydrides. Further useful binders are polymers in which groups with acid hydrogen atoms are present, some or all of which are converted with activated isocyanates. Examples of these polymers are products obtained by conversion of hydroxyl-containing polymers with aliphatic or aromatic sulfonyl isocyanates or phosphinic acid isocyanates. Also suitable are polymers with aliphatic or aromatic hydroxyl groups, for example copolymers containing units of hydroxyalkyl (meth)acrylates, allyl alcohol, hydroxystyrene or vinyl alcohol, as well as epoxy resins, provided they carry a sufficient number of free OH groups. Particular useful binder and particular useful reactive binders are disclosed in EP 1 369 232, EP 1 369 231, EP 1 341 040, US 2003/0124460, EP 1 241 002, EP 1 288 720, US 6,027,857, US 6,171,735 and US 6,420,089. Other suitable binders are disclosed in EP 152 819 B1 on page 2 lines 50-page 4 line 20, and in EP 1 043 627 B1 on paragraph [0013] on page 3.

The polymeric binder may also comprise a hydrophobic backbone, and pendant groups including for example a hydrophilic poly(alkylene oxide) segment. The polymeric binder may also include pendant cyano groups attached to the hydrophobic backbone. A combination of such binders may also be employed. Generally the polymeric binder is a solid at room temperature, and is typically a non-elastomeric thermoplastic. The polymeric binder comprises both hydrophilic and hydrophobic regions, which is thought to be important for enhancing differentiation of the exposed and unexposed areas by facilitating developability. Generally the polymeric binder is characterized by a number average molecular weight (Mn)in the range from about 10.000 to 250.000, more commonly in the range from about 25.000 to 200.000. The polymerizable composition may comprise discrete particles of the polymeric binder. Preferably the discrete particles are particles of the polymeric binder which are suspended in the polymerizable composition. The presence of discrete particles tends to promote developability of the unexposed areas. Specific examples of the polymeric binders according to this embodiment are described in US 6.899.994, 2004/0260050, US2005/0003285, US2005/0170286 and US2005/0123853. In addition to the polymeric binder of this embodiment the imageable layer may optionally comprise one or more co-binders. Typical co-binders are water-soluble or water-dispersible polymers, such as, cellulose derivatives, poly vinyl alcohol, poly acrylic acid poly(meth)acrylic acid, poly vinyl pyrrolidone, polylactide, poly vinyl phosphonic acid, synthetic copolymers, such as the co-polymer of an alkoxy polyethylene glycol (meth)acrylate. Specific examples of co-binders are described in US2004/0260050, US2005/0003285 and US2005/0123853. Printing plate precursors, the imageable layer of which comprises a binder and optionally a co-binder according this embodiment and described in more detail in US2004/0260050, US2005/0003285 and US2005/0123853, optionally comprises a topcoat and an interlayer.

### Surfactant

Various surfactants may be added into the photopolymerizable layer to allow or enhance the developability of the precursor with a gum solution. Both polymeric and small molecule surfactants can be used. Nonionic surfactants are preferred. Preferred nonionic surfactants are polymers and oligomers containing one or more polyether (such as polyethylene glycol, polypropylene glycol, and copolymer of ethylene glycol and propylene glycol) segments. Examples of preferred nonionic surfactants are block copolymers of propylene glycol and ethylene glycol (also called block copolymer of propylene oxide and ethylene oxide); ethoxylated or propoxylated acrylate oligomers; and polyethoxylated alkylphenols and polyethoxylated fatty alcohols. The nonionic surfactant is preferably added in an amount ranging between 0.1 and 30% by weight of the coating, more preferably between 0.5 and 20%, and most preferably between 1 and 15%.

### Sensitizer

The photocurable composition may also comprise a sensitizer. Highly preferred sensitizers are violet light absorbing sensitizers, having an absorption spectrum between 350 nm and 450 nm, preferably between 370 nm and 420 nm, more preferably between 390 nm and 415 nm. Particular preferred sensitizers are disclosed in EP 1 349 006 paragraph [0007] to [0009], EP-A-3103499, filed on 22/09/2003, and WO2004/047930, including the cited references in these patent applications. Other highly preferred sensitizers are infrared light absorbing dyes, having an absorption spectrum between 750 nm and 1300 nm, preferably between 780 nm and 1200 nm, more preferably between 800 nm and 1100 nm. Particular preferred sensitizers are heptamethinecyane dyes, specially the dyes disclosed in EP 1 359 008 paragraph [0030] to [0032]. Other preferred sensitizers are blue, green or red light absorbing sensitizers, having an absorption spectrum between 450 nm and 750 nm. Useful sensitizers can be selected from the sensitizing dyes disclosed in US 6,410,205, US 5,049,479, EP 1 079 276, EP 1 369 232, EP 1 369 231, EP 1 341 040, US 2003/0124460, EP 1 241 002 and EP 1 288 720.

### Printing-out agent

The photopolymerizable layer or another layer of the coating may also comprise a printing-out agent, i.e. a compound which is capable of changing the color of the coating upon exposure. After image-wise exposing of the precursor, a visible image is produced, hereinafter also referred to as "print-out image". The contrast of the image formed after exposure has to be as high as possible. This enables the end-user to establish immediately whether or not the precursor has already been exposed, to inspect the image quality on the printing plate and to distinguish the different color selections. Since development of the plate is not carried out before starting the printing process, a previous inspection and discrimination of the plate is not possible unless a print-out image is formed by the image-wise exposure. A high contrast of the print-out image is defined by a color distance of at least 3,measured between the exposed and non-exposed areas, preferably at least 4. The color distance is defined by the CIE color coordinates, lightness and chroma, as described by CIE 15.2-1986: Colorimetry, CIE 1116-1995: Industrial Colour Difference Evaluation, or R.W.G. Hunt in Measuring Colour, second edition, edited in 1992 by Ellis Horwood Limited, England, and are calculated from the spectral density curve of the exposed and non-exposed areas following the "CIE 1976 Colour Difference" formulae as described in the same document.

The printing-out agent may be a compound as described in EP-A-1 491 356 paragraph [0116] to [0119] on page 19 and 20, and in US 2005/8971 paragraph [0168] to [0172] on page 17. Preferred printing-out agents are the compounds described in the unpublished PCT Application PCT/EP 2005/053141, filed on 1 July 2005, from line 1 page 9 to line 27 page 20. More preferred are the IR-dyes as described in the unpublished Patent Application EP 05 105 440.1, filed on 21 June 2005, from line 32 page 5 to line 9 page 32. The IR-dyes of this application may be added to the coating of the present invention or may replace, at least partially, the IR-absorbing compound present in the coating of the present invention.

### Colorant

The photopolymerizable layer or another layer of the coating may also comprise a colorant. The colorant can be a dye or a pigment. A dye or pigment can be used as a colorant when the layer, comprising the dye or pigment, is colored for the human eye.

The colorant can be a pigment. Various types of pigments can be used such as organic pigments, inorganic pigments, carbon black, metallic powder pigments and fluorescent pigments. Organic pigments are preferred.

Specific examples of organic pigments include quinacridone pigments, quinacridonequinone pigments, dioxazine pigments, phthalocyanine pigments, anthrapyrimidine pigments, anthanthrone pigments, indanthrone pigments, flavanthrone pigments, perylene pigments, diketopyrrolopyrrole pigments, perinone pigments, quinophthalone pigments, anthraquinone pigments, thioindigo pigments, benzimidazolone pigments, isoindolinone pigments, azomethine pigments, and azo pigments.

Specific examples of pigments usable as colorant are the following (herein is C.I. an abbreviation for Color Index; under a Blue colored pigment is understood a pigment that appears blue for the human eye; the other colored pigments have to be understood in an analogue way) :
- Blue colored pigments which include C.I. Pigment Blue 1, C.I. Pigment Blue 2, C.I. Pigment Blue 3, C.I. Pigment Blue 15 : 3, C.I. Pigment Blue 15 : 4, C.I. Pigment Blue 15 : 34, C.I. Pigment Blue 16, C.I. Pigment Blue 22, C.I. Pigment Blue 60 and the like; and C.I. Vat Blue 4, C.I. Vat Blue 60 and the like;
- Red colored pigments which include C.I. Pigment Red 5, C.I. Pigment Red 7, C.I. Pigment Red 12, C.I. Pigment Red 48 (Ca), C.I. Pigment Red 48 (Mn), C.I. Pigment Red 57 (Ca), C.I. Pigment Red 57 : 1, C.I. Pigment Red 112, C.I. Pigment Red 122, C.I. Pigment Red 123, C.I. Pigment Red 168, C.I. Pigment Red 184, C.I. Pigment Red 202, and C.I. Pigment Red 209;
- Yellow colored pigments which include C.I. Pigment Yellow 1, C.I. Pigment Yellow 2, C.I. Pigment Yellow 3, C.I. Pigment Yellow 12, C.I. Pigment Yellow 13, C.I. Pigment Yellow 14C, C.I. Pigment Yellow 16, C.I. Pigment Yellow 17, C.I. Pigment Yellow 73, C.I. Pigment Yellow 74, C.I. Pigment Yellow 75, C.I. Pigment Yellow 83, C.I. Pigment Yellow 93, C.I. Pigment Yellow 95, C.I. Pigment Yellow 97, C.I. Pigment Yellow 98, C.I. Pigment Yellow 109, C.I. Pigment Yellow 110, C.I. Pigment Yellow 114, C.I. Pigment Yellow 128, C.I. Pigment Yellow 129, C.I. Pigment Yellow 138, C.I. Pigment Yellow 150, C.I. Pigment Yellow 151, C.I. Pigment Yellow 154, C.I. Pigment Yellow 155, C.I. Pigment Yellow 180, and C.I. Pigment Yellow 185;
- Orange colored pigments include C.I. Pigment Orange 36, C.I. Pigment Orange 43, and a mixture of these pigments. Green colored pigments include C.I. Pigment Green 7, C.I. Pigment Green 36, and a mixture of these pigments;
- Black colored pigments include: those manufactured by Mitsubishi Chemical Corporation, for example, No. 2300, No. 900, MCF 88, No. 33, No. 40, No. 45, No. 52, MA 7, MA 8, MA 100, and No. 2200 B; those manufactured by Columbian Carbon Co., Ltd., for example, Raven 5750, Raven 5250, Raven 5000, Raven 3500, Raven 1255, and Raven 700; those manufactured by Cabot Corporation, for example, Regal 400 R, Regal 330 R, Regal 660 R, Mogul L, Monarch 700, Monarch 800, Monarch 880, Monarch 900, Monarch 1000, Monarch 1100, Monarch 1300, and Monarch 1400; and those manufactured by Degussa, for example, Color Black FW 1, Color Black FW 2, Color Black FW 2 V, Color Black FW 18, Color Black FW 200, Color Black S 150, Color Black S 160, Color Black S 170, Printex 35, Printex U, Printex V, Printex 140 U, Special Black 6, Special Black 5, Special Black 4A, and Special Black 4.
Other types of pigments such as brown pigments, violet pigments, fluorescent pigments and metallic powder pigments can also be used as colorant. The pigments may be used alone or as a mixture of two or more pigments as colorant.

Blue colored pigments, including cyan pigments, are preferred.

The pigments may be used with or without being subjected to surface treatment of the pigment particles. Preferably, the pigments are subjected to surface treatment. Methods for surface treatment include methods of applying a surface coat of resin, methods of applying surfactant, and methods of bonding a reactive material (for example, a silane coupling agent, an epoxy compound, polyisocyanate, or the like) to the surface of the pigment. Suitable examples of pigments with surface treatment are the modified pigments described in WO 02/04210. Specifically the blue colored modified pigments described in WO 02/04210 are preferred as colorant in the present invention.

The pigments have a particle size which is preferably less than 10 µm, more preferably less than 5 µm and especially preferably less than 3 µm. The method for dispersing the pigments may be any known dispersion method which is used for the production of ink or toner or the like. Dispersing machines include an ultrasonic disperser, a sand mill, an attritor, a pearl mill, a super mill, a ball mill, an impeller, a dispenser, a KD mill, a colloid mill, a dynatron, a three-roll mill and a press kneader. Details thereof are described in " Latest Pigment Applied Technology" (CMC Publications, published in 1986).

A dispersing agent may be omitted in the preparation of dispersions of so-called self-dispersing pigments. Specific examples of self-dispersing pigments are pigments with are subjected to a surface treatment in such a way the pigment surface is compatible with the dispersing liquid. Typical examples of self-dispersing pigments in an aqueous medium are pigments which have ionic or ionisable groups or polyethyleneoxide chains coupled to the particle-surface. Examples of ionic or ionisable groups are acid groups or salts thereof such as carboxylic acid group, sulphonic acid, phosphoric acid or phosphonic acid and alkali metal salts of these acids. Suitable examples of self-dispersing pigments are described in WO 02/04210 and these are preferred in the present invention. The blue colored self-dispersing pigments in WO 02/04210 are preferred.

Typically, the amount of pigment in the coating may be in the range of about 0.005 g/m² to 2 g/m² , preferably about 0.007 g/m² to 0.5 g/m², more preferably about 0.01 g/m² to 0.2 g/m², most preferably about 0.01 g/m² to 0.1 g/m².

The colorant can also be a dye. Any known dyes, such as commercially available dyes or dyes described in, for example, "Dye Handbook" (edited by the Organic Synthetic Chemistry Association, published in 1970) which are colored for the human eye, can be used as colorant in the photopolymerizable coating. Specific examples thereof include azo dyes, metal complex salt azo dyes, pyrazolone azo dyes, anthraquinone dyes, phthalacyanine dyes, carbionium dyes, quinonimine dyes, methine dyes, and the like. Phthalocyanine dyes are preferrred. Suitable dyes are salt-forming organic dyes and may be selected from oil-soluble dyes and basic dyes. Specific examples thereof are (herein is CI an abbreviation for Color Index): Oil Yellow 101, Oil Yellow 103, Oil Pink 312, Oil Green BG, Oil Bue GOS, Oil Blue 603, Oil Black BY, Oil Black BS, Oil Black T-505, Victoria Pure Blue, Crystal Violet (CI42555), Methyl Violet (CI42535), Ethyl Violet, Rhodamine B (CI415170B), Malachite Green (CI42000), Methylene Blue (CI52015). Also, the dyes dislosed in GB 2 192 729 may be used as colorant.

Typically, the amount of dye in the coating may be in the range of about 0.005 g/m² to 2 g/m², preferably about 0.007 g/m² to 0.5 g/m², more preferably about 0.01 g/m to 0.2 g/m², most preferably about 0.01 g/m² to 0.1 g/m².

### The top layer

The coating may comprise a top layer which acts as an oxygen barrier layer, hereinafter also referred to as "overcoat layer" or "overcoat". Preferred binders which can be used in the top layer are polyvinyl alcohol and the polymers disclosed in EP-A-3103498, filed on 22/09/2003, US 6,410,205 and EP 1 288 720, including the cited references in these patents and patent applications. The most preferred binder for the toplayer is polyvinylalcohol. The polyvinylalcohol has preferably an hydrolysis degree ranging between 74 mol % and 99 mol %. The weight average molecular weight of the polyvinylalcohol can be measured by the viscosity of an aqueous solution, 4 % by weight, at 20°C as defined in DIN 53 015, and this viscosity number ranges preferably between 3 and 26, more preferably between 3 and 15, most preferably between 3 and 10.

The coating thickness of the top layer is preferably between 0.25 and 1.75 g/m², more preferably between 0.25 and 1.3 g/m², most preferably between 0.25 and 1.0 g/m². In a more preferred embodiment of the present invention, the toplayer has a coating thickness between 0.25 and 1.75 g/m² and comprises a polyvinylalcohol having an hydrolysis degree ranging between 74 mol % and 99 mol % and a viscosity number as defined above ranging between 3 and 26.

In a preferred embodiment, the composition and the thickness of of the toplayer are optimised in order to obtain a high sensitivity, a good daylight stability and less or no contamination of fountain and/or ink during on-press processing. In order to reduce contaminition, the toplayer comprises less polyvinylalcohol and polyvinylalcohol with a lower molecular weight, preferably a viscosity number of less than 26, more preferably less than 10 is used and a thickness as low as possible but more than 0.25 g/m². In order to improve the sensitivity, the good oxygen barrier is desired, using a polyvinylalcohol with a high hydrolysis degree, preferably 88-98%, and a bigger thickness or the toplayer. In order to improve the daylight stability, small penetration of oxygen is desired by a using an oxygen barrier with reduced barrier property for oxygen, preferably by using a smaller thickness of the toplayer and with polyvinylalcohol having a lower hydrolysis degree. Due to a good balance of these elements, an optimised property for the precursor can be obtained.

The top layer may also comprise a component selected from the compounds of a gum solution as disclosed in the unpublished PCT Application PCT/EP 2005/052298, filed on 18 May 2005, from lines 1 on page 5 to line 35 on page 11.

### Exposure

The image-wise exposing step can be carried out off-press in a plate setter, i.e. an exposure apparatus suitable for image-wise exposing the precursor by a laser such as a laser diode, emitting around 830 nm, a NdYAG laser, emitting around 1060 nm, a violet laser, emitting around 400 nm or a gas laser such as Ar laser, by digital modulated UV-exposure, e.g. by means of digital mirror devices, or by a conventional exposure in contact with a mask. In a preferred embodiment of the present invention, the precursor is image-wise exposed by a laser emitting IR-light or violet light.

The image-wise exposing step can also carried-out in an on press configuration whereby the precursor is mounted on a plate cylinder and image-wise exposed with a laser.

### Preheating

After this image-wise exposing step, the precursor may be heated in a preheating unit to enhance or to speed-up the polymerization and/or crosslinking reaction. In a preferred embodiment, this preheat step may be carried out within a time period of less than 10 minutes, preferably less than 5 minutes, more preferably less than 1 minute, most preferably the preheat is carried out immediately after the image-wise exposing, i.e. within less than 30 seconds. There is no time limit before the heating step may start, but the precursor is heated as soon as possible after exposing, usually after a few seconds to transport the plate to the preheating unit and start the heating process. In this preheating step, the precursor is heated at a temperature of preferably 80°C to 150°C and during a dwell time of preferably 5 seconds to 1 minute. The preheating unit is preferably provided with heating elements such as IR-lamps, UV-lamps, heated air, a heated metal roll, etc.

### On-press processing

The exposed, optionally exposed and preheated, precursor is processed on-press, i.e. while the precursor is mounted on the plate cylinder of a lithographic printing press, by rotating said plate cylinder while feeding dampening liquid and/or ink to the coating of the precursor. In a preferred embodiment, only dampening liquid is supplied to the plate during start-up of the press. After a number of revolutions of the plate cylinder, preferably less than 50 and most preferably less than 5 revolutions, also the ink supply is switched on. In an alternative embodiment, supply of dampening liquid and ink can be started simultaneously or only ink can be supplied during a number of revolutions before switching on the supply of dampening liquid.

In another embodiment of the present invention, the precursor may be exposed and processed on-press, i.e. after step (a) and before step (b), an additional step (a') is provided wherein the precursor is mounted on a plate cylinder of a lithographic printing press, and wherein step (d) is not present; optionally, after step (b) and before step (e), an additional pre-heat step (c') is provided. In this additional pre-heat step (c') the image-wise exposed precursor is heated at a temperature ranging between 80 and 150°C during a dwell time of 5 seconds to 1 minute, and within a time period preferably of less than 5 minutes, more preferably less than 1 minute, most preferably the preheat is carried out immediately after the image-wise exposing, i.e. within less than 30 seconds.

### EXAMPLES

### Preparation of aluminum support S-1:

A 0.3 mm thick aluminum foil was degreased by spraying with an aqueous solution containing 34 g/l of NaOH at 70°C for 6 seconds and rinsed with demineralized water for 3.6 seconds. The foil was then electrochemically grained during 8 seconds using an alternating current in an aqueous solution containing 15 g/l of HCl, 15 g/l of SO₄²⁻ ions and 5 g/l of Al³⁺ ions at a temperature of 37°C and a current density of about 100 A/dm². Afterwards, the aluminum foil was desmutted by etching with an aqueous solution containing 145 g/l of sulfuric acid at 80°C for 5 seconds and rinsed with demineralized water for 4 seconds. The foil was subsequently subjected to anodic oxidation during 10 seconds in an aqueous solution containing 145 g/l of sulfuric acid at a temperature of 57°C and a current density of 33 A/dm², then washed with demineralized water for 7 seconds and post-treated for 4 seconds by spraying a solution containing 2.2 g/l of polyvinylphosphonic acid at 70°C, rinsed with demineralized water for 3.5 seconds and dried at 120°C for 7 seconds.

The support thus obtained was characterized by a surface roughness Ra of 0.35 à 0.4 µm, measured with interferometer NT1100, and had an anodic weight of 4.0 g/m².

### Preparation of aluminum support S-2:

The preparation of this support is carried out in the same way as described for support S-1 with the exception that the polyvinyl phosphonic acid layer is partially removed by treatment with PD91, a water-based alkaline developer solution, commercially available from Agfa-Gevaert, followed by washing with water.

### Preparation of aluminum support S-3:

The preparation of this support is carried out in the same way as described for support S-1 with the exception that the post-anodic treatment with the polyvinyl phosphonic acid solution is omitted and the substrate is washed with demineralised water.

### Preparation of aluminum support S-4:

A 0.3 mm thick aluminum foil was degreased by spraying with an aqueous solution containing 34 g/l of NaOH at 70°C for 6 seconds and rinsed with demineralized water for 3.6 seconds. The foil was then electrochemically grained during 8 seconds using an alternating current in an aqueous solution containing 15 g/l of HCl, 15 g/l of SO₄² ions and 5 g/l of Al³⁺ ions at a temperature of 37°C and a current density of about 120-130 A/dm². Afterwards, the aluminum foil was desmutted by etching with an aqueous solution containing 145 g/1 of sulfuric acid at 80°C for 5 seconds and rinsed with demineralized water for 4 seconds. The foil was subsequently subjected to anodic oxidation during 10 seconds in an aqueous solution containing 145 g/l of sulfuric acid at a temperature of 57°C and a current density of 25 A/dm², then washed with demineralized water for 7 seconds and post-treated for 4 seconds by spraying a solution containing 2.2 g/1 of polyvinylphosphonic acid at 70°C, rinsed with demineralized water for 3.5 seconds and dried at 120°C for 7 seconds.

The support thus obtained was characterized by a surface roughness Ra of 0.50 à 0.65 µm, measured with interferometer NT1100, and had an anodic weight of 3.0 g/m².

### Preparation of aluminum support S-5:

The preparation of this support is carried out in the same way as described for support S-4 with the exception that the polyvinyl phosphonic acid layer is partially removed by treatment with PD91, a water-based alkaline developer solution, commercially available from Agfa-Gevaert, followed by washing with water.

### Preparation of intermediate layers I-1 to I-6 :

The coating compositions for the intermediate layers I-1 to I-6 were prepared by mixing the ingredients as specified in Table 1. The resulting solutions were coated with a bar-coater on a support. After coating, the plate was dried for 1 minute at 120°C in a circulation oven.

**Table 1: Compositions of the intermediate layer solutions and thickness of dried layer.**

| COMPOSITION / INGREDIENTS | I-1 | I-2 | I-3 | I-4 | I-5 | I-6 |
|---|---|---|---|---|---|---|
| Sipomer PAM 100 (1) (g) | 0.50 | 0.3 | 3.325 | 1.0 | 1.88 | 3.75 |
| Dowanol PM (2) (g) | 125 | 50 | 593.88 | 125 | 125 | 125 |
| Butanone (g) | | | 398.47 | | | |
| Dry thickness (g/m²) | 0.04 | 0.06 | 0.06 | 0.08 | 0.15 | 0.30 |

| | | | | | | |
|---|---|---|---|---|---|---|
| (1) Sipomer PAM 100 is a phosphate functional speciality methacrylate monomer, obtained from RHODIA. This compound was treated by extraction with methyl-tert-butylether, collection of the lower phase, and subsequent addition of 250 ppm (parts per million) of para-methoxyphenol. (2) Dowanol PM is propylene glycol monomethylether, trade mark of Dow Chemical Company. | | | | | | |

### Preparation of photosensitive layers P-1 to P-6:

The coating compositions for the photosensitive layers P-1 to P-6 were prepared by mixing the ingredients as specified in Table 2. The resulting solutions were coated with a bar-coater on a support or on an intermediate layer. After coating, the plate was dried for 1 minute at 120°C in a circulation oven. The resulting applied amount is 0.75 g/m² for photosensitive layer P-2 and 1.50 g/m² for the other photosensitive layers.

The polyvinyl acetate binders with a high hydrolysis degree used in P-3 and P4 are incompatible with the photosensitive composition resulting in flocculation of composition (see further in Table 5).

**Table 2: Compositions of the photosensitive layer solutions.**

| COMPOSITION / INGREDIENTS | P-1 | P-2 | P-3 | P-4 | P-5 | P-6 |
|---|---|---|---|---|---|---|
| Alcotex 552P (1) (g) | 3.75 | 3.75 | | | | |
| Mowiol 4/88(2) (g) | | | 3.75 | | | |
| Mowiol 6/98(3) (g) | | | | 3.75 | | |
| Luvitec K30 (4) (g) | | | | | 1.03 | |
| KL 7177 (5) (g) | | | | | | 3.75 |
| IR-dye-01 (6) (g) | 0.0794 | 0.1775 | 0.0794 | 0.0794 | 0.10 | 0.0794 |
| TBMPS (7) (g) | 0.1984 | 0.2219 | 0.1984 | 0.1984 | 0.15 | 0.1984 |
| FST 426R (8) (g) | 1.859 | 2.0375 | 1.859 | 1.859 | 1.43 | 1.859 |
| Edaplan LA411 (9) (g) | 0.3375 | 0.3750 | 0.3375 | 0.3375 | 0.026 | 0.3375 |
| Dowanol PM (g) | 36.88 | 39.63 | 36.88 | 36.88 | 15.10 | 36.88 |
| Butanone (g) | | | | | 10.81 | |

| | | | | | | |
|---|---|---|---|---|---|---|
| (1) Alcotex 552P is a 40% by weight solution in water of polyvinylalcohol having a hydrolysis degree of 55 mol%, commercially available from Synthomer (2) Mowiol 4/88 is a polyvinylalcohol having a hydrolysis degree of 88 mol%, commercially available from Clariant (3) Mowiol 6/98 is a polyvinylalcohol having a hydrolysis degree of 98 mol%, commercially available from Clariant (4) Luvitec K30 is a polyvinylpyrrolidone, commercially available from BASF (5) KL 7177 is a solution containing 32.4 wt.% of a methylmethacrylate/methacrylic acid copolymer (ratio 4:1 by weight; acid number: 110 mg KOH/g) in 2-butanone (viscosity 105 mm²/s at 25°C) (6) IR-dye-01 has the following structure 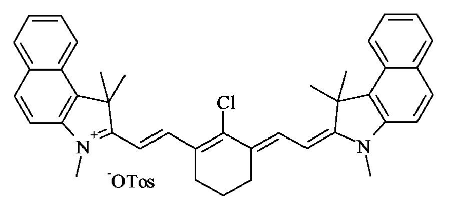 wherein OTos represents a tosylate anion (7) TBMPS is tri-bromo-methylphenyl-sulphone (8) FST 426R is a solution in 2-butanone containing 88.2 wt.% of a reaction product from 1 mole of 2,2,4-trimethyl-hexamethylenediisocyanate and 2 moles of hydroxyethylmethacrylate (viscosity 3.30 mm²/s at 25°C) (9) Edaplan LA411 is a surfactant (1 % solution in Dowanol PM® trade mark of Dow Chemical Company) obtained from Munzing Chemie. | | | | | | |

### Preparation of overcoat layer OC-1 and OC-2:

On top of the photosensitive layer a solution in water with the composition as defined in Table 3 was coated and was dried at 110°C for 2 minutes. The so-formed protective overcoat had a dry thickness of 2.0 g/m².

**Table 3: Composition of overcoat solution.**

| COMPONENT | OC-1 | OC-2 |
|---|---|---|
| partially hydrolyzed polyvinylalcohol (degree of hydrolysis 88 %, viscosity 4 mPa•-s in a solution of 4 wt.% at 20 °C) (g) | 17.03 | 17.04 |
| partially hydrolyzed polyvinylalcohol (degree of hydrolysis 88 %, viscosity 8 mPa•s in a solution of 4 wt.% at 20 °C) (g) | 7.43 | 7.43 |
| fully hydrolyzed polyvinylalcohol (degree of hydrolysis 98 %, viscosity 6 mPa•s in a solution of 4 wt.% at 20 °C) (g) | 14.87 | 14.87 |
| Acticide LA1206 (1) (g) | 0.26 | 0.08 |
| Metolat FC 355 (2) (g) | 0.38 | |
| Lupasol P (3) (g) | | 0.40 |
| Lutensol A8 (90%) (4) (g) | 0.032 | 0.38 |
| Water (g) | 960 | 959.8 |

| | | |
|---|---|---|
| (1) Acticide LA1206 is a biocide, commercially available from Thor (2) Metolat FC 355 is an ethoxylated ethylenediamine, commercially available from Münzing Chemie (3) Lupasol P is a solution of 50% by weight of a polyethylene imine in water, commercially available from BASF (4) Lutensol A8 (90%) is a surface active agent, commercially available from BASF | | |

### Image formation and on-press processing

After drying of the overcoat layer, the plates were imaged with a Creo Trendsetter IR laser (830 nm) at different energies varying between 100 mJ/cm² and 300 mJ/cm².

After exposure, the plates were mounted on a GTO46 printing press (available from Heidelberger Druckmaschinen AG), and a print job was started using K + E Novavit 800 Skinnex ink (trademark of BASF Drucksysteme GmbH) and 3% FS101 (trademark of AGFA) in 10% isopropanol as fountain liquid, compressible blanket and by using offset paper.

The clean-out is defined by the number of sheets needed to obtain on the non-exposed areas on optical density of 0.0 while on the full exposed areas (or the 100 % dot areas of a screen) the optical density is at least 1.5, indicating an excellent ink-acceptance. The indication <5 means that a full clean-out is obtained after printing 2, 3 or 4 sheets; >1000 means that no clean-out is obtained after printing 1000 sheets.

The sensitivity is defined as the minimum exposing energy at which the 2% dots of a 200 lpi screen were still present on the printed paper after 1000 prints.

Table 5 summarizes the compositions of the printing plate precursors and the obtained results.

**Table 5: Precursor composition and results.**

| EXAMPLE number | Al support | Intermediate layer | Photosensitive layer | Overcoat layer | Clean-out (number sheets) | Sensitivity (mJ/m²) |
|---|---|---|---|---|---|---|
| Invention Example 1 | S-2 | I-6 | P-2 | OC-1 | <5 | 100 |
| Invention Example 2 | S-2 | I-6 | P-1 | OC-1 | <5 | 200 |
| Comparative Example 1 | S-2 | I-6 | P-3 | OC-1 | Flocculation of P-3 | |
| Comparative Example 2 | S-2 | I-6 | P-4 | OC-1 | Flocculation of P-4 | |
| Comparative Example 3 | S-5 | I-3 | P-5 | OC-2 | >1000 | No image |
| Comparative Example 4 | S-2 | 1-6 | P-6 | OC-1 | >1000 | No image |
| Invention Example 3 | S-2 | I-5 | P-2 | OC-1 | <5 | 100 |
| Invention Example 4 | S-2 | I-5 | P-1 | OC-1 | <5 | 200 |
| Invention Example 5 | S-2 | I-4 | P-2 | OC-1 | <5 | 100 |
| Invention Example 6 | S-2 | I-4 | P-1 | OC-1 | <5 | 200 |
| Invention Example 7 | S-1 | I-4 | P-1 | OC-1 | <5 | 275 |
| Invention Example 8 | S-1 | I-1 | P-1 | OC-1 | <5 | 275 |
| Invention Example 9 | S-3 | I-2 | P-2 | OC-1 | <5 | 150 |

The invention examples in Table 5 demonstrate that printing plate precursors comprising a binder of the present invention in the photopolymerizable layer and having an adhesion promoting compound in an intermediate layer, exhibit an excellent clean-out in the on-press processing: a full clean-out is obtained after printing less than 5 sheets. In the comparative examples, no clean-out can be obtained, even after printing a high number of sheets, or no printing plate precursor can be prepared due to flocculation of the coating solution of the photopolymerizable layer.

### Preparation of photosensitive layers P-7 to P-9:

The coating compositions for the photosensitive layers P-7 to P-9 were prepared by mixing the ingredients as specified in Table 6. The resulting solutions were coated with a bar-coater on one of the above described supports. After coating, the plate was dried for 1 minute at 120°C in a circulation oven. The resulting applied amount is 1.50 g/m² for these photosensitive layers.

**Table 6: Compositions of the photosensitive layer solutions.**

| COMPOSITION / INGREDIENTS | P-7 | P-8 | P-9 |
|---|---|---|---|
| Alcotex 552P (1) (g) | 3.125 | 3.125 | 3.125 |
| IR-dye-01 (2) (g) | 0.0794 | 0.0794 | 0.0794 |
| TBMPS (3) (g) | 0.1875 | 0.1875 | 0.1875 |
| FST 426R (4) (g) | 1.680 | 1.680 | 1.592 |
| Edaplan LA411 (5) (g) | 0.3375 | 0.3375 | 0.3375 |
| Sipomer PAM 100 (6) (g) | 0.078 | | |
| Geniosil GF31 (7) (g) | | 0.078 | 0.156 |
| Dowanol PM (g) | 37.50 | 37.50 | 37.50 |

| | | | |
|---|---|---|---|
| (1) to (5) see Table 2 (6) see Table 1 (7) Geniosil GF31 is 3-methacryloxypropyl-tri-methoxy-silane (> 97% purity), obtained from Wacker Silicones. | | | |

### Image formation and on-press processing

After drying of the overcoat layer, the plates were imaged and on-press processed as described above for Invention Examples 1 to 9.

Table 7 summarizes the compositions of the printing plate precursors, having no intermediate layer, and the obtained results.

**Table 7: Precursor composition and results.**

| EXAMPLE number | Al support | Intermediate layer | Photosensitive layer | Over-coat layer | Clean-out (number sheets) | Sensitivity (mJ/m²) |
|---|---|---|---|---|---|---|
| Comparative Example 5 | S-3 | - | P-2 | OC-1 | >1000 | No image |
| Comparative Example 6 | S-2 | - | P-2 | OC-1 | >1000 | No image |
| Comparative Example 7 | S-1 | - | P-1 | OC-1 | >1000 | No image |
| Invention Example 10 | S-1 | - | P-7 | OC-1 | <5 | 300 |
| Invention Example 11 | S-2 | - | P-8 | OC-1 | <5 | 300 |
| Invention Example 12 | S-2 | - | P-9 | OC-1 | <5 | 300 |

The invention examples in Table 7 demonstrate that for printing plate precursors comprising a binder of the present invention in the photopolymerizable layer an excellent clean-out in the on-press processing is obtained when an adhesion promoting compound is also present in the photopolymerizable layer.

## Claims

1. A method of making a lithographic printing plate comprising the steps of:
(a) providing a lithographic printing plate precursor comprising
(i) a support having a hydrophilic surface or which is provided with a hydrophilic layer, and
(ii) a coating provided thereon,
wherein said coating comprises a photopolymerizable layer and, optionally, an intermediate layer between the photopolymerizable layer and the support,
wherein said photopolymerizable layer comprises a polymerizable compound, a polymerization initiator and a partially hydrolysed polyvinyl acetate, and
wherein an adhesion promoting compound is present in the intermediate layer or in the photopolymerizable layer,
wherein said adhesion promoting compound is a compound capable of interacting with said support,
(b) image-wise exposing said precursor,
(c) optionally, heating the precursor in a preheating unit,
(d) mounting the exposed precursor on a plate cylinder of a lithographic printing press,
(e) developing by rotating the plate cylinder while feeding dampening liquid and/or ink to the coating, thereby removing non-exposed areas of the coating,
**characterised in that** said polyvinyl acetate has a hydrolysis degree of less than 60 mol%.

2. A method according to claim 1, wherein said polyvinyl acetate has a hydrolysis degree of at most 58 mol% and at least 20 mol%.

3. A method according to claim 1, wherein said polyvinyl acetate has a hydrolysis degree of at most 56 mol% and at least 40 mol%.

4. A method according to any of the preceding claims, wherein said adhesion promoting compound is a compound having an ethylenically unsaturated bond and a functional group capable of interacting with the support.

5. A method according to claim 4, wherein said functional group comprises a phosphate group, a phosphonate group or a trialkoxy silane group.

6. A method according to any of the preceding claims, wherein said polyvinyl acetate is present in said photopolymerizable layer in an amount ranging between 10 and 90 % by weight relative to the total weight of the layer.

7. A method according to any of the preceding claims, wherein said adhesion promoting compound is present in said photopolymerizable layer in an amount ranging between 1 and 50% by weight relative to the total weight of the layer.

8. A method according to any of the preceding claims, wherein said adhesion promoting compound is present in said intermediate layer in an amount ranging between 50 and 100% by weight relative to the total weight of the layer.

9. A method according to any of the preceding claims, wherein said photopolymerizable layer further comprises an TR-absorbing compound and wherein, in step (b), said precursor is image-wise exposed to heat or IR-radiation.

10. A method according to any of the preceding claims 1 to 8, wherein said photopolymerizable layer further comprises a violet absorbing compound and wherein, in step (b), said precursor is image-wise exposed to violet light.

## Patentansprüche

1. Ein Verfahren zur Herstellung einer lithografischen Druckplatte, das die folgenden Schritte umfasst :
a) Bereitstellen einer lithografischen Druckplattenvorstufe, umfassend :
(i) einen Träger mit einer hydrophilen Oberfläche oder einen mit einer hydrophilen Schicht versehenen Träger und
(ii) eine auf den Träger angebrachte Beschichtung,
wobei die Beschichtung eine fotopolymerisierbare Schicht und gegebenenfalls eine zwischen der fotopolymerisierbaren Schicht und dem Träger eingefügte Zwischenschicht umfasst,
wobei die fotopolymerisierbare Schicht eine polymerisierbare Verbindung, einen Polymerisationsinitiator und ein teilhydrolysiertes Polyvinylacetat enthält und
wobei die Zwischenschicht oder die fotopolymerisierbare Schicht eine haftungsfördernde Verbindung enthält,
wobei die haftungsfördernde Verbindung in der Lage ist, eine Wechselwirkung mit dem Träger einzugehen,
b) bildmäßige Belichtung der Vorstufe,
c) gegebenenfalls die Erwärmung der Vorstufe in einer Vorwärmeinheit,
d) das Aufspannen der belichteten Vorstufe auf einen Plattenzylinder einer lithografischen Druckmaschine und
e) die Entwicklung durch Benetzen und/oder Einfärben der Beschichtung unter drehendem Plattenzylinder, wobei die unbelichteten Bereiche der Beschichtung entfernt werden,
**dadurch gekennzeichnet, dass** das Polyvinylacetat einen Hydrolysegrad unter 60 mol-% aufweist.

2. Verfahren nach Anspruch 1, **dadurch gekennzeichnet, dass** das Polyvinylacetat einen Hydrolysegrad zwischen höchstens 58 mol-% und mindestens 20 mol-% aufweist.

3. Verfahren nach Anspruch 1, **dadurch gekennzeichnet, dass** das Polyvinylacetat einen Hydrolysegrad zwischen höchstens 56 mol-% und mindestens 40 mol-% aufweist.

4. Verfahren nach einem der vorstehenden Ansprüche, **dadurch gekennzeichnet, dass** die haftungsfördernde Verbindung eine Verbindung ist, die eine ethylenisch ungesättigte Bindung und eine funktionelle Gruppe, die in der Lage ist, eine Wechselwirkung mit dem Träger einzugehen, enthält.

5. Verfahren nach Anspruch 4, **dadurch gekennzeichnet, dass** die funktionelle Gruppe eine Phosphatgruppe, eine Phosphonatgruppe oder eine Trialkoxysilangruppe ist.

6. Verfahren nach einem der vorstehenden Ansprüche, **dadurch gekennzeichnet, dass** das Polyvinylacetat in einem Verhältnis zwischen 10 Gew.-% und 90 Gew.-%, bezogen auf das Gesamtgewicht der fotopolymerisierbaren Schicht, in der fotopolymerisierbaren Schicht enthalten ist.

7. Verfahren nach einem der vorstehenden Ansprüche, **dadurch gekennzeichnet, dass** die haftungsfördernde Verbindung in einem Verhältnis zwischen 1 Gew.-% und 50 Gew.-%, bezogen auf das Gesamtgewicht der fotopolymerisierbaren Schicht, in der fotopolymerisierbaren Schicht enthalten ist.

8. Verfahren nach einem der vorstehenden Ansprüche, **dadurch gekennzeichnet, dass** die haftungsfördernde Verbindung in einem Verhältnis zwischen 50 Gew.-% und 100 Gew.-%, bezogen auf das Gesamtgewicht der Zwischenschicht, in der Zwischenschicht enthalten ist.

9. Verfahren nach einem der vorstehenden Ansprüche, **dadurch gekennzeichnet, dass** die fotopolymerisierbare Schicht ferner eine Infrarotstrahlung absorbierende Verbindung enthält und die Vorstufe im Schritt (b) mit Wärme oder Infrarotstrahlung bildmäßig belichtet wird.

10. Verfahren nach einem der vorstehenden Ansprüche 1 bis 8, **dadurch gekennzeichnet, dass** die fotopolymerisierbare Schicht ferner eine Violettstrahlung absorbierende Verbindung enthält und die Vorstufe im Schritt (b) mit Violettlicht bildmäßig belichtet wird.

## Revendications

1. Un procédé pour la confection d'une plaque d'impression lithographique, comprenant les étapes ci-après :
a) la mise à disposition d'un précurseur de plaque d'impression lithographique comprenant :
(i) un support ayant une surface hydrophile ou un support revêtu d'une couche hydrophile et
(ii)un revêtement appliqué sur le support,
ledit revêtement comprenant une couche photopolymérisable et éventuellement une couche intermédiaire insérée entre la couche photopolymérisable et le support,
ladite couche photopolymérisable contenant un composé polymérisable, un initiateur de polymérisation et un acétate de polyvinyle partiellement hydrolysé et
un composé améliorant l'adhésion étant présent dans la couche intermédiaire ou dans la couche photopolymérisable,
ledit composé améliorant l'adhésion étant un composé capable d'interagir avec le support,
b) l'exposition sous forme d'image du précurseur,
c) éventuellement le chauffage du précurseur dans une unité de préchauffage,
d) le calage du précurseur exposé sur un cylindre porte-plaque d'une machine à imprimer lithographique et
e) le développement par mouillage du revêtement avec une solution de gommage et/ou par encrage du revêtement pendant que le cylindre porte-plaque tourne, permettant l'élimination des zones non exposées du revêtement,
**caractérisé en ce que** l'acétate de polyvinyle présente un degré d'hydrolyse inférieur à 60 moles %.

2. Procédé selon la revendication 1, **caractérisé en ce que** l'acétate de polyvinyle présente un degré d'hydrolyse compris entre 58 moles % au maximum et 20 moles % au minimum.

3. Procédé selon la revendication 1, **caractérisé en ce que** l'acétate de polyvinyle présente un degré d'hydrolyse compris entre 56 moles % au maximum et 40 moles % au minimum.

4. Procédé selon l'une quelconque des revendications précédentes, **caractérisé en ce que** le composé améliorant l'adhésion est un composé comprenant une liaison à insaturation éthylénique et un groupe fonctionnel capable d'interagir avec le support.

5. Procédé selon la revendication 4, **caractérisé en ce que** le groupe fonctionnel est un groupe phosphate, un groupe phosphonate ou un groupe trialkoxysilane.

6. Procédé selon l'une quelconque des revendications précédentes, **caractérisé en ce que** l'acétate de polyvinyle est contenu dans la couche photopolymérisable dans un rapport compris entre 10 et 90% en poids par rapport au poids total de la couche.

7. Procédé selon l'une quelconque des revendications précédentes, **caractérisé en ce que** le composé améliorant l'adhésion est contenu dans la couche photopolymérisable dans un rapport compris entre 1 et 50% en poids par rapport au poids total de la couche.

8. Procédé selon l'une quelconque des revendications précédentes, **caractérisé en ce que** le composé améliorant l'adhésion est contenu dans la couche intermédiaire dans un rapport compris entre 50 et 100% en poids par rapport au poids total de la couche.

9. Procédé selon l'une quelconque des revendications précédentes, **caractérisé en ce que** la couche photopolymérisable contient en outre un composé absorbant les rayons infrarouges et qu'à l'étape (b), le précurseur est exposé sous forme d'image à de la chaleur ou à des rayons infrarouges.

10. Procédé selon l'une quelconque des revendications précédentes 1 à 8, **caractérisé en ce que** la couche photopolymérisable contient en outre un composé absorbant les rayons violets et qu'à l'étape (b), le précurseur est exposé sous forme d'image à des rayons violets.
